# EUROPÄISCHE PATENTANMELDUNG

(11) **EP 3 168 992 A1**
(43) Veröffentlichungstag der Anmeldung: **17.05.2017**
(21) Anmeldenummer: 15003223.3
(22) Anmeldetag: 11.11.2015
(51) Int. Cl.: H03K 17/14, H03K 17/955, H03K 17/96

(54) **BEDIENVORRICHTUNG UND VERFAHREN ZUM BETREIBEN EINER BEDIENVORRICHTUNG**

(71) Anmelder: Diehl AKO Stiftung & Co. KG, 88239 Wangen (DE)
(72) Erfinder: Dulski, Bartosz, PL - 55-080 Mokronos Górny (PL)
(74) Vertreter: Diehl Patentabteilung

(57) **Zusammenfassung**

Eine Bedienvorrichtung für ein elektronisches Haushaltsgerät weist eine Abdeckplatte (10) mit einer einem Benutzer zugewandten Benutzerseite (12) und einer der Benutzerseite abgewandten Innenseite (14); eine Trägerplatte (18), die auf der Seite der Innenseite (14) der Abdeckplatte (10) mit einem Abstand zu dieser angeordnet ist; und ein Bedienelement (24a..d), das auf der Trägerplatte (18) montiert ist, auf. Zusätzlich ist ein Feuchtigkeitssensor (27) zum Erfassen eines Vorhandenseins einer Flüssigkeit in der Bedienvorrichtung vorgesehen. Eine Steuereinrichtung (26) steht mit dem Bedienelement (24a..d) und mit dem Feuchtigkeitssensor (27) in Verbindung und ist derart ausgestaltet, dass sie das Bedienelement (24a..d) in Abhängigkeit von dem durch den Feuchtigkeitssensor (27) erfassten Vorhandensein einer Flüssigkeit betreibt.

## Beschreibung

Die vorliegende Erfindung betrifft eine elektronische Schaltung, eine Bedienvorrichtung, ein elektronisches Haushaltsgerät mit einer solchen Bedienvorrichtung und ein Verfahren zum Betreiben einer Bedienvorrichtung.

Je nach Anwendungsfall kann es in elektronischen Schaltungen vorkommen, dass Feuchtigkeit kondensiert und sich Wassertropfen auf den elektronischen Komponenten oder Leitungen bilden, welche die Funktionsfähigkeit der Schaltung beeinträchtigen können. So werden zum Beispiel in Kochfeldern mit Strahlungsheizkörpern in der Regel Keramikelemente verbaut, welche aus der Luft Feuchtigkeit absorbieren können. Nach einer längeren Betriebspause der Strahlungsheizkörper verdampft dann die absorbierte Feuchtigkeit beim Aufheizen sehr schnell und die heiße feuchte Luft trifft auf die kalte Oberfläche der elektronischen Schaltung bzw. ihrer Leiterplatte, wo sie kondensiert. Die kondensierte Feuchtigkeit kann dann bei verschiedenen Bauteilen und Schaltungstopologien zu Problemen führen. So hat der Erfinder zum Beispiel erkannt, dass berührungsempfindliche Tastschalter mit kapazitivem Funktionsprinzip von einem solchen Kondenswasser beeinflusst werden können.

Es ist daher die Aufgabe der vorliegenden Erfindung, eine verbesserte elektronische Schaltung zu schaffen, deren Funktionsweise auch bei vorhandener Feuchtigkeit zuverlässig gewährleistet werden kann. Es sollen ferner eine verbesserte Bedienvorrichtung, ein verbessertes elektronisches Haushaltsgerät und ein verbessertes Verfahren zum Betreiben einer Bedienvorrichtung bereitgestellt werden, welche die gleichen Vorteile bieten.

Diese Aufgabe wird gelöst durch die Lehre der unabhängigen Ansprüche. Besonders bevorzugte Ausgestaltungen und Weiterbildungen der Erfindung sind Gegenstand der abhängigen Ansprüche.

Die elektronische Schaltung der Erfindung weist eine Trägerplatte, eine auf der Trägerplatte montierte elektronische Komponente, einen Feuchtigkeitssensor zum Erfassen eines Vorhandenseins einer Flüssigkeit auf der elektronischen Schaltung und eine Steuereinrichtung auf. Die Steuereinrichtung steht mit der elektronischen Komponente und mit dem Feuchtigkeitssensor in Verbindung und ist derart ausgestaltet, dass sie die elektronische Komponente in Abhängigkeit von dem durch den Feuchtigkeitssensor erfassten Vorhandensein einer Flüssigkeit betreibt.

Gemäß der Erfindung wird vorgeschlagen, das Vorhandensein von Flüssigkeit auf der elektronischen Schaltung zu erfassen und die elektronische(n) Komponente(n) der elektronischen Schaltung in Abhängigkeit von dem Erfassungsergebnis zu betreiben. Durch die Anpassung des Betriebs der elektronische(n) Komponente(n) an das Vorhandensein oder Nicht-Vorhandensein von Flüssigkeit kann eine zuverlässige Funktionsweise der elektronischen Schaltung auch bei vorhandener Flüssigkeit oder Feuchtigkeit gewährleistet werden.

Das Betreiben der elektronische(n) Komponente(n) soll in diesem Zusammenhang alle Arten von Betriebsverfahren umfassen, die bei der jeweiligen elektronischen Komponente möglich sind. Hierzu zählen insbesondere, aber nicht ausschließlich, das Ein- und Ausschalten der Komponente, das Ansteuern der Komponente, das Auswerten von Signalen von der Komponente und dergleichen.

Der Begriff elektronische Komponente soll in diesem Zusammenhang alle Arten von Bauteilen umfassen, die in einer elektronischen Schaltung vorhanden sein können. Hierzu zählen insbesondere, aber nicht ausschließlich, Sensoren, Messelektroden, Kondensatoren, Induktivitäten, Widerstände, Transistoren, Mikrocontroller, Leiterbahnen und dergleichen.

Der Begriff Feuchtigkeitssensor soll in diesem Zusammenhang zunächst alle Arten von Vorrichtungen umfassen, die geeignet sind, Feuchtigkeit und/oder Flüssigkeiten zu erfassen. In einer bevorzugten Ausgestaltung der Erfindung ist der Feuchtigkeitssensor ein kapazitiver Feuchtigkeitssensor, der wenigstens eine auf der Trägerplatte montierte Messelektrode aufweist. Die Steuereinrichtung ist in diesem Fall vorzugsweise derart ausgestaltet, dass sie ein Vorhandensein einer Flüssigkeit auf der elektronischen Schaltung aus einem Kapazitätswert oder einer Kapazitätswertänderung einer mit der wenigstens einen Messelektrode gebildeten Kapazität erfasst. Vorzugsweise weist der Feuchtigkeitssensor mehrere Messelektroden auf und die Steuereinrichtung wertet die Kapazitätswerte bzw. die Kapazitätswertänderungen zwischen den mehreren Messelektroden aus. Die Messelektroden können einzeln oder gemeinsam mit der Steuereinrichtung verbunden sein. Alternativ oder zusätzlich kann eine Messelektrode auch zusammen mit einem anderen Potenzial, insbesondere einem Massepotenzial eine Kapazität bilden, deren Kapazitätswert(änderung) ausgewertet werden kann.

Der kapazitive Feuchtigkeitssensor stellte eine besonders einfach und kompakt aufgebaute Art eines Feuchtigkeitssensors dar. Außerdem ist ein kapazitiver Feuchtigkeitssensor einfach in die elektronische Schaltung zu integrieren.

In einer weiteren bevorzugten Ausgestaltung der Erfindung ist die elektronische Komponente auf der einen Seite der Trägerplatte angeordnet und ist der Feuchtigkeitssensor oder die wenigstens eine Messelektrode des Feuchtigkeitssensors auf der anderen Seite der Trägerplatte angeordnet.

In einer anderen bevorzugten Weiterbildung der Erfindung ist die elektronische Komponente und der Feuchtigkeitssensor oder die wenigstens eine Messelektrode des Feuchtigkeitssensors auf der gleichen Seite der Trägerplatte angeordnet.

In einer weiteren Alternative sind elektronische Komponenten und Feuchtigkeitssensoren oder Messelektroden der Feuchtigkeitssensoren auf beiden Seiten der Trägerplatte angeordnet.

Die Bedienvorrichtung der Erfindung weist eine Abdeckplatte mit einer einem Benutzer zugewandten Benutzerseite und einer der Benutzerseite abgewandten Innenseite; eine Trägerplatte, die auf der Seite der Innenseite der Abdeckplatte mit einem Abstand zu dieser angeordnet ist; ein Bedienelement, das auf der Trägerplatte montiert ist; einen Feuchtigkeitssensor zum Erfassen eines Vorhandenseins einer Flüssigkeit in der Bedienvorrichtung; und eine Steuereinrichtung, die mit dem Bedienelement und mit dem Feuchtigkeitssensor in Verbindung steht, auf. Die Steuereinrichtung ist dabei derart ausgestaltet, dass sie das Bedienelement in Abhängigkeit von dem durch den Feuchtigkeitssensor erfassten Vorhandensein einer Flüssigkeit betreibt.

Mit dieser Bedienvorrichtung können die gleichen Vorteile erzielt werden wie oben in Zusammenhang mit der elektronischen Schaltung der Erfindung beschrieben.

Die Erfindung ist insbesondere bei Bedienvorrichtungen vorteilhaft einsetzbar, die in feuchten Umgebungen (z.B. Küchen, Waschräumen, etc.) und/oder in Geräten mit größeren Temperaturschwankungen (z.B. Kochfelder, etc.) betrieben werden.

Der Begriff Bedienelement soll in diesem Zusammenhang alle Arten von Bedienelementen umfassen, die von einem Benutzer betätigt werden können und deren Ausgangssignale von einer Steuereinrichtung ausgewertet werden können. Hierzu zählen insbesondere, aber nicht ausschließlich, Tastschalter, Kippschalter, Schieberegler, Drehknebel und dergleichen.

In einer bevorzugten Ausgestaltung der Erfindung ist der Feuchtigkeitssensor ein kapazitiver Feuchtigkeitssensor, der wenigstens eine auf der Trägerplatte montierte Messelektrode aufweist. In diesem Fall ist die Steuereinrichtung vorzugsweise derart ausgestaltet, dass sie ein Vorhandensein einer Flüssigkeit in der Bedienvorrichtung aus einem Kapazitätswert oder einer Kapazitätswertänderung einer mit der wenigstens einen Messelektrode gebildeten Kapazität erfasst.

In einer weiteren bevorzugten Ausgestaltung der Erfindung ist das Bedienelement ein berührungs- oder annäherungsempfindliches Bedienelement, insbesondere ein kapazitives berührungs- oder annäherungsempfindliches Bedienelement. Die vorliegende Erfindung ist insbesondere in Kombination mit kapazitiv funktionierenden Bedienelementen von Vorteil, da diese Bedienelemente bzw. deren Ausgangssignale von Feuchtigkeit / Flüssigkeit zum Beispiel stärker beeinflusst werden als optische Sensoren.

In einer weiteren bevorzugten Ausgestaltung der Erfindung ist das Bedienelement auf der einen Seite der Trägerplatte angeordnet und ist der Feuchtigkeitssensor oder die wenigstens eine Messelektrode des Feuchtigkeitssensors auf der anderen Seite der Trägerplatte angeordnet.

In einer weiteren bevorzugten Ausgestaltung der Erfindung ist das Bedienelement auf einer der Abdeckplatte zugewandten Oberseite der Trägerplatte angeordnet und ist der Feuchtigkeitssensor oder die wenigstens eine Messelektrode des Feuchtigkeitssensors auf der Oberseite der Trägerplatte oder einer der Abdeckplatte abgewandten Unterseite der Trägerplatte angeordnet.

In einer anderen bevorzugten Weiterbildung der Erfindung ist das Bedienelement und der Feuchtigkeitssensor oder die wenigstens eine Messelektrode des Feuchtigkeitssensors auf der gleichen Seite der Trägerplatte angeordnet.

In einer weiteren Alternative sind Bedienelemente und Feuchtigkeitssensoren oder Messelektroden der Feuchtigkeitssensoren auf beiden Seiten der Trägerplatte angeordnet.

Gegenstand der Erfindung ist ferner ein elektronisches Haushaltsgerät, das eine oben beschriebene Bedienvorrichtung der Erfindung aufweist.

Zu den elektronischen Haushaltsgeräten, in denen die erfindungsgemäße Bedienvorrichtung vorteilhaft einsetzbar ist, zählen insbesondere, aber nicht ausschließlich, Kochfelder, Herde, Mikrowellenöfen, Spülmaschinen, Wäschebehandlungsgeräte (Waschmaschinen, Wäschetrockner, etc.), Kühl- und/oder Gefriergeräte und dergleichen.

Bei dem Verfahren zum Betreiben einer Bedienvorrichtung mit einer Abdeckplatte mit einer einem Benutzer zugewandten Benutzerseite und einer der Benutzerseite abgewandten Innenseite, einer Trägerplatte, die auf der Seite der Innenseite der Abdeckplatte mit einem Abstand zu dieser angeordnet ist, und einem auf der Trägerplatte montierten Bedienelement wird ein Vorhandensein einer Flüssigkeit in der Bedienvorrichtung erfasst und wird das Bedienelement in Abhängigkeit von dem erfassten Vorhandensein einer Flüssigkeit betrieben.

Mit diesem Betriebsverfahren einer Bedienvorrichtung können die gleichen Vorteile erzielt werden wie oben in Zusammenhang mit der elektronischen Schaltung der Erfindung beschrieben.

In einer bevorzugten Ausgestaltung der Erfindung wird das Vorhandensein einer Flüssigkeit in der Bedienvorrichtung mittels eines kapazitiven Feuchtigkeitssensors erfasst, der wenigstens eine auf der Trägerplatte montierte Messelektrode aufweist.

In einer weiteren bevorzugten Ausgestaltung der Erfindung ist das Bedienelement auf der einen Seite der Trägerplatte angeordnet und wird das Vorhandensein einer Flüssigkeit auf der anderen Seite der Trägerplatte erfasst.

In einer weiteren bevorzugten Ausgestaltung der Erfindung wird in Abhängigkeit von dem erfassten Vorhandensein einer Flüssigkeit in der Bedienvorrichtung eine Signalauswertung des Bedienelements angepasst. Vorzugsweise wird das Bedienelement anhand des Erfassungsergebnisses des Feuchtigkeitssensors nachkalibriert, sodass die Auswertung der Signale des Bedienelements auch bei vorhandener Feuchtigkeit / Flüssigkeit zu den richtigen Ergebnissen führen kann.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine Schnittansicht eines Teils einer Bedienvorrichtung gemäß einem Ausführungsbeispiel der vorliegenden Erfindung; und
- Fig. 2: einen Schaltplan eines Teils einer Bedienvorrichtung gemäß einem Ausführungsbeispiel der vorliegenden Erfindung.

Die vorliegende Erfindung wird nachfolgend am Beispiel einer Bedienvorrichtung für ein Kochfeld in mehr Einzelheiten erläutert, ohne dass die Erfindung auf diese Anwendung beschränkt sein soll.

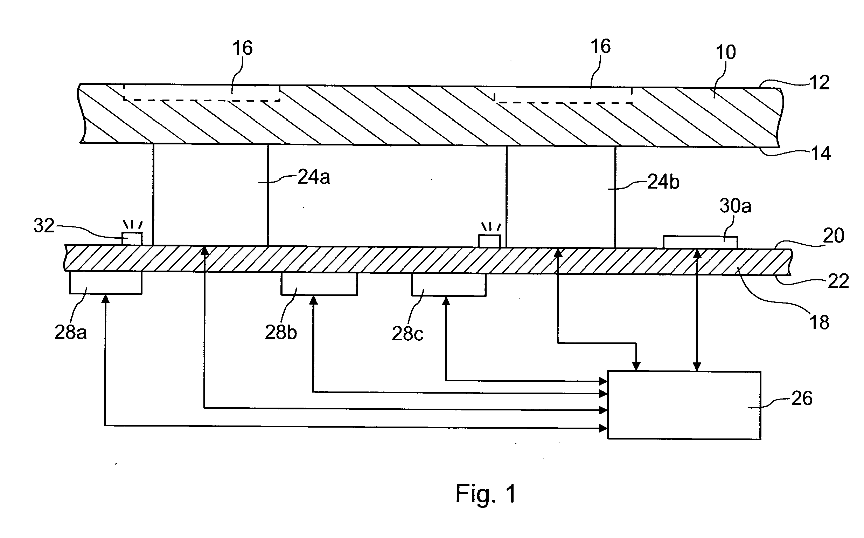

Die Bedienvorrichtung weist eine Abdeckplatte 10 zum Beispiel in Form einer Kunststoffplatte oder einer Glaskeramikplatte eines Kochfeldes auf. Bei der Ausführungsform von Fig. 1 ist die Abdeckplatte aus einem elektrisch nicht leitfähigen Material gefertigt, in anderen Ausführungsformen der Erfindung sind aber auch Abdeckplatten zum Beispiel aus Metall möglich. Die Abdeckplatte 10 hat eine dem Benutzer der Bedienvorrichtung zugewandte, außen liegende Benutzerseite 12 (oben in Fig. 1) und eine dem Benutzer abgewandte Innenseite 14 (unten in Fig. 1). Die Abdeckplatte 10 definiert zudem mehrere Bedienfelder 16 entsprechend den mehreren berührungs- oder annäherungsempfindlichen Bedienelementen der Bedienvorrichtung.

Hinter der Abdeckplatte 10, d.h. auf der dem Benutzer abgewandten Seite, ist mit Abstand zur Abdeckplatte 10 eine Trägerplatte 18 angeordnet. Bei der Trägerplatte 18 handelt es sich vorzugsweise um eine Leiterplatte, und die Trägerplatte 18 ist vorzugsweise im Wesentlichen parallel zur Abdeckplatte 10 angeordnet. Die Trägerplatte 18 hat eine der Abdeckplatte 10 zugewandte Oberseite 20 (oben in Fig. 1) und eine der Abdeckplatte 10 abgewandte Unterseite 22 (unten in Fig. 1).

Auf der Oberseite 20 der Trägerplatte 10 sind mehrere elektronische Komponenten 24a..d montiert, die in diesem Ausführungsbeispiel als kapazitive Sensorelemente in Form von Elektroden ausgebildet sind. Diese Elektroden 24a..d bilden zusammen mit zum Beispiel einem Finger eines Benutzers auf dem Bedienfeld 16 der Abdeckplatte 10 eine Kapazität, wobei die Abdeckplatte 10 dazwischen als Dielektrikum funktioniert. Der Kapazitätswert dieser Kapazität ändert sich entsprechend dem Berühren oder Nicht-Berühren des Bedienfeldes 16 durch den Benutzer.

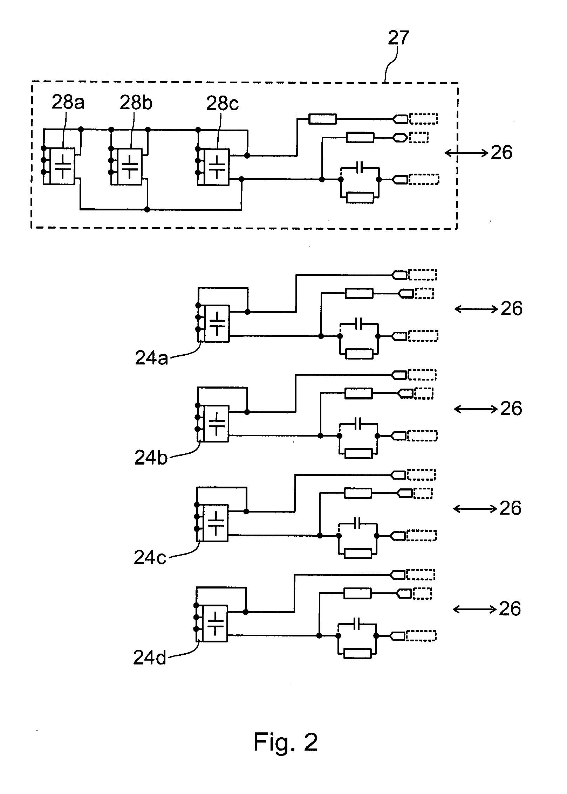

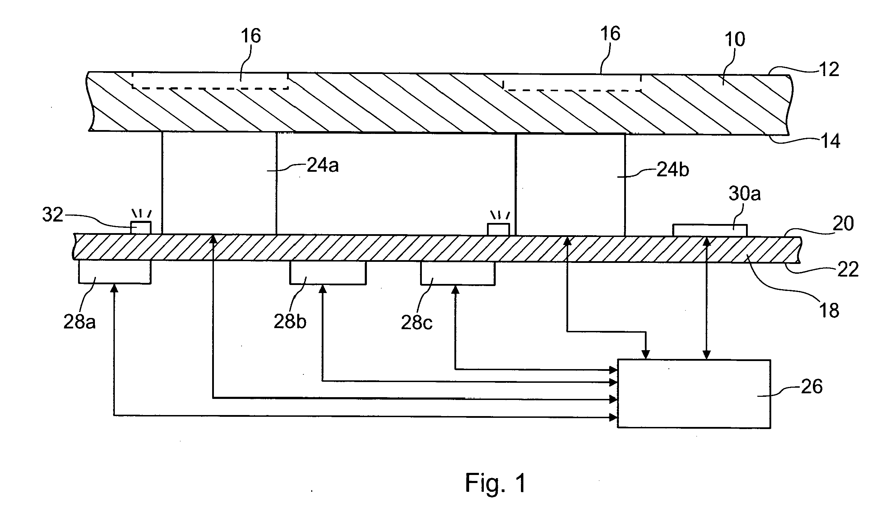

Wie in Fig. 2 veranschaulicht, sind die Elektroden 24a..d jeweils mit einer Sensorschaltung gekoppelt, die mit einer Steuereinrichtung 26 verbunden ist. Die Steuereinrichtung 26, die zum Beispiel einen Mikrocontroller aufweist, wertet die Ausgangssignale der Sensorschaltungen der Bedienelemente 24a..d aus und schließt daraus auf ein Betätigen oder Nicht-Betätigen der einzelnen Bedienelemente durch einen Benutzer.

Im Betrieb einer solchen Bedienvorrichtung kann es wie eingangs der Beschreibung erläutert vorkommen, dass Feuchtigkeit innerhalb der Bedienvorrichtung auf der Trägerplatte 18 und/oder den elektronischen Komponenten auf der Trägerplatte 18 kondensiert. Die dabei gebildeten Kondenswassertropfen können die Ausgangssignale der Sensorschaltungen der Bedienelemente 24a..d beeinflussen, sodass deren Auswertung durch die Steuereinrichtung 26 zu fehlerhaften Ergebnissen führen kann.

Aus diesem Grund ist auf der Trägerplatte 18 zudem wenigstens ein Feuchtigkeitssensor 27 montiert, der das Vorhandensein von Flüssigkeit (d.h. Wassertropfen) auf der Trägerplatte 18 bzw. den elektronischen Komponenten 24a..d und den Leitungsbahnen erfassen soll. Im Ausführungsbeispiel der Fig. 1 und 2 ist der Feuchtigkeitssensor 27 als ein kapazitiver Feuchtigkeitssensor ausgebildet, ohne dass die Erfindung auf diese Ausgestaltung beschränkt sein soll.

Wie in Fig. 1 und 2 dargestellt, weist der kapazitive Feuchtigkeitssensor 27 mehrere Messelektroden 28a, 28b, 28c auf, die auf der Unterseite 22 der Trägerplatte 18 montiert sind. Diese Messelektroden 28a..c sind mit einer Sensorschaltung gekoppelt, die wiederum mit der Steuereinrichtung 26 verbunden ist. Die mehreren Messelektroden 28a..c bilden jeweils Kapazitäten zwischen sich. Wassertropfen auf oder zwischen den Messelektroden 28a..c verändern die Kapazitätswerte dieser Kapazitäten. Die Sensorschaltung erfasst diese Kapazitätswertänderungen und die Steuereinrichtung 26 wertet die Messsignale der Sensorschaltung des Feuchtigkeitssensors 27 aus.

Wenn die Steuereinrichtung 26 anhand der Messsignale der Sensorschaltung des Feuchtigkeitssensors 27 erkennt, das in der Bedienvorrichtung Feuchtigkeit - zum Beispiel in Form von Wassertropfen auf/zwischen den Messelektroden 28a..c des Feuchtigkeitssensors 27 - vorhanden ist, dann passt die Steuereinrichtung 26 den Betrieb der Bedienelemente 24a..d und ggf. auch weiterer elektronischer Komponenten auf der Trägerplatte 18 entsprechend an. In Bezug auf die kapazitiven, berührungs- oder annäherungsempfindlichen Bedienelemente 24a..d nimmt die Steuereinrichtung 26 vorzugsweise eine Nachkalibrierung vor, sodass anschließend die Messsignale der Sensorschaltungen der Bedienelemente 24a..d korrekt ausgewertet werden können und zu den beabsichtigten Ergebnissen führen. Das Nachkalibrieren enthält zum Beispiel ein Anpassen eines Auswertealgorithmus, einer Filterung, einer Signalverstärkung und dergleichen. Bei anderen elektronischen Komponenten können diese durch die Steuereinrichtung 26 ggf. auch ausgeschaltet werden oder in einer anderen Weise angesteuert werden (z.B. mit veränderter Eingangsleistung, mit veränderter Taktfrequenz, etc.).

Der kapazitive Feuchtigkeitssensor 27 ist in besonders einfacher und kompakter Weise in eine Bedienvorrichtung mit kapazitiven Bedienelementen 24a..d integrierbar. Einerseits ist der kapazitive Feuchtigkeitssensor 27 einfach und kompakt aufgebaut, zudem ist seine Sensorschaltung analog zu den Sensorschaltungen der Bedienelemente 24a..d aufgebaut.

In dem beschriebenen Ausführungsbeispiel sind die Bedienelemente 24a..d auf der einen Seite, nämlich der Oberseite 20 der Trägerplatte 18 montiert, während der Feuchtigkeitssensor 27 bzw. seine Messelektroden 28a..c auf der anderen Seite, nämlich der Unterseite 22 der Trägerplatte 18 montiert sind. Alternativ oder zusätzlich ist es auch möglich, einen Feuchtigkeitssensor mit seinen Messelektroden 30a... ebenfalls auf der Oberseite 20 der Trägerplatte 18 zu montieren, wie in Fig. 1 angedeutet. In anderen Ausgestaltungen der Erfindungen ist es auch möglich, die Bedienelemente 24a..d auf der Unterseite 22 der Trägerplatte 18 vorzusehen.

Während in dem Ausführungsbeispiel von Fig. 1 und 2 ein kapazitiver Feuchtigkeitssensor mit mehreren Messelektroden, zwischen denen die Kapazitäten gebildet sind, verwendet wird, ist es alternativ auch möglich, kapazitive Feuchtigkeitssensoren zu verwenden, deren Kapazitäten durch eine Messelektrode und ein weiteres Potenzial (z.B. Massepotenzial) an einem anderen Bauelement, einer Gehäusekomponente, etc. gebildet werden. Grundsätzlich sind auch andere Feuchtigkeitssensoren, die nicht auf einem kapazitiven Funktionsprinzip beruhen, im Rahmen dieser Erfindung einsetzbar.

Neben den Bedienelementen 24a..d bzw. deren kapazitiven Sensorelementen sind auf der Trägerplatte 18 üblicherweise weitere elektronische Komponenten montiert. Zu diesen weiteren elektronischen Komponenten zählen zum Beispiel Lichtquellen (z.B. Leuchtdioden) 32 zum Hinterleuchten oder optischen Kennzeichnen der Bedienfelder 16 der Abdeckplatte 10, Anzeigeelemente (z.B. Displays, etc.), Transistoren, Induktivitäten, Leiterbahnen und dergleichen sowie weitere Bedienelemente anderer Bauart (z.B. mit optischen Sensoren, piezoelektrischen Elementen, etc.).

Während in dem Ausführungsbeispiel von Fig. 1 und 2 Bedienelemente mit kapazitiven Sensorelementen in Form von Elektroden auf der Trägerplatte 18 montiert sind, können auch andere kapazitive Bedienelemente (z.B. mit zusätzlichen elastischen Elementen, Lichtleitelementen, etc.) und andere berührungs- oder annäherungsempfindliche Bedienelemente (z.B. optisch, induktiv, piezoelektrisch) zum Einsatz kommen.

### BEZUGSZIFFERNLISTE

- 10: Abdeckplatte
- 12: Benutzerseite von 10
- 14: Innenseite von 10
- 16: Bedienfeld
- 18: Trägerplatte, z.B. Leiterplatte
- 20: Oberseite von 18
- 22: Unterseite von 18
- 24a..d: elektronische Komponenten, z.B. kapazitive Sensorelemente
- 26: Steuereinrichtung
- 27: Feuchtigkeitssensor
- 28a..c: Messelektroden
- 30a...: Messelektroden
- 32: Lichtquellen, z.B. Leuchtdioden

## Patentansprüche

1. Elektronische Schaltung, aufweisend:
eine Trägerplatte (18);
eine elektronische Komponente (24a..d), die auf der Trägerplatte (18) montiert ist;
einen Feuchtigkeitssensor (27) zum Erfassen eines Vorhandenseins einer Flüssigkeit auf der elektronischen Schaltung; und
eine Steuereinrichtung (26), die mit der elektronischen Komponente (24a..d) und mit dem Feuchtigkeitssensor (27) in Verbindung steht, wobei die Steuereinrichtung (26) ausgestaltet ist, um die elektronische Komponente (24a..d) in Abhängigkeit von dem durch den Feuchtigkeitssensor (27) erfassten Vorhandensein einer Flüssigkeit zu betreiben.

2. Elektronische Schaltung nach Anspruch 1, bei welcher der Feuchtigkeitssensor (27) ein kapazitiver Feuchtigkeitssensor ist, der wenigstens eine auf der Trägerplatte (18) montierte Messelektrode (28a..c; 30a...) aufweist; und
die Steuereinrichtung (26) ausgestaltet ist, um ein Vorhandensein einer Flüssigkeit auf der elektronischen Schaltung aus einem Kapazitätswert oder einer Kapazitätswertänderung einer mit der wenigstens einen Messelektrode (28a..c; 30a...) gebildeten Kapazität zu erfassen.

3. Elektronische Schaltung nach Anspruch 1 oder 2, bei welcher die elektronische Komponente (24a..d) auf einer Seite (20) der Trägerplatte (18) angeordnet ist und der Feuchtigkeitssensor (27) oder die wenigstens eine Messelektrode (28a..c) des Feuchtigkeitssensors (27) auf einer anderen Seite (22) der Trägerplatte (18) angeordnet ist.

4. Bedienvorrichtung, insbesondere für ein elektronisches Haushaltsgerät, aufweisend:
eine Abdeckplatte (10) mit einer einem Benutzer zugewandten Benutzerseite (12) und einer der Benutzerseite abgewandten Innenseite (14);
eine Trägerplatte (18), die auf der Seite der Innenseite (14) der Abdeckplatte (10) mit einem Abstand zu dieser angeordnet ist;
ein Bedienelement (24a..d), das auf der Trägerplatte (18) montiert ist;
einen Feuchtigkeitssensor (27) zum Erfassen eines Vorhandenseins einer Flüssigkeit in der Bedienvorrichtung; und
eine Steuereinrichtung (26), die mit dem Bedienelement (24a..d) und mit dem Feuchtigkeitssensor (27) in Verbindung steht, wobei die Steuereinrichtung (26) ausgestaltet ist, um das Bedienelement (24) in Abhängigkeit von dem durch den Feuchtigkeitssensor (27) erfassten Vorhandensein einer Flüssigkeit zu betreiben.

5. Bedienvorrichtung nach Anspruch 4, bei welcher
der Feuchtigkeitssensor (27) ein kapazitiver Feuchtigkeitssensor ist, der wenigstens eine auf der Trägerplatte (18) montierte Messelektrode (28a..c; 30a...) aufweist; und
die Steuereinrichtung (26) ausgestaltet ist, um ein Vorhandensein einer Flüssigkeit in der Bedienvorrichtung aus einem Kapazitätswert oder einer Kapazitätswertänderung einer mit der wenigstens einen Messelektrode (28a..c; 30a...) gebildeten Kapazität zu erfassen.

6. Bedienvorrichtung nach Anspruch 4 oder 5, bei welcher das Bedienelement (24a..d) ein berührungs- oder annäherungsempfindliches Bedienelement, insbesondere ein kapazitives berührungs- oder annäherungsempfindliches Bedienelement ist.

7. Bedienvorrichtung nach einem der Ansprüche 4 bis 6, bei welcher das Bedienelement (24a..d) auf einer Seite (20) der Trägerplatte (18) angeordnet ist und der Feuchtigkeitssensor (27) oder die wenigstens eine Messelektrode (28a..c) des Feuchtigkeitssensors (27) auf einer anderen Seite (22) der Trägerplatte (18) angeordnet ist.

8. Bedienvorrichtung nach einem der Ansprüche 4 bis 7, bei welcher das Bedienelement (24a..d) auf einer der Abdeckplatte (10) zugewandten Oberseite (20) der Trägerplatte (18) angeordnet ist und der Feuchtigkeitssensor (27) oder die wenigstens eine Messelektrode (28a..c; 30a...) des Feuchtigkeitssensors (27) auf der Oberseite (20) der Trägerplatte (18) oder einer der Abdeckplatte (10) abgewandten Unterseite (22) der Trägerplatte (18) angeordnet ist.

9. Elektronisches Haushaltsgerät, mit einer Bedienvorrichtung nach einem der Ansprüche 4 bis 8.

10. Verfahren zum Betreiben einer Bedienvorrichtung, insbesondere einer Bedienvorrichtung eines elektronischen Haushaltsgerät, mit einer Abdeckplatte (10) mit einer einem Benutzer zugewandten Benutzerseite (12) und einer der Benutzerseite abgewandten Innenseite (14), einer Trägerplatte (18), die auf der Seite der Innenseite (14) der Abdeckplatte (10) mit einem Abstand zu dieser angeordnet ist, und einem auf der Trägerplatte montierten Bedienelement (24a..d), bei welchem
ein Vorhandensein einer Flüssigkeit in der Bedienvorrichtung erfasst wird; und
das Bedienelement (24a..d) in Abhängigkeit von dem erfassten Vorhandensein einer Flüssigkeit betrieben wird.

11. Verfahren nach Anspruch 10, bei welchem
das Vorhandensein einer Flüssigkeit in der Bedienvorrichtung mittels eines kapazitiven Feuchtigkeitssensors (27) erfasst wird, der wenigstens eine auf der Trägerplatte (18) montierte Messelektrode (28a..c; 30a...) aufweist.

12. Verfahren nach Anspruch 10 oder 11, bei welchem
das Bedienelement (24a..d) auf einer Seite (20) der Trägerplatte (18) angeordnet ist und das Vorhandensein einer Flüssigkeit auf einer anderen Seite (22) der Trägerplatte (18) erfasst wird.

13. Verfahren nach einem der Ansprüche 10 bis 12, bei welchem
in Abhängigkeit von dem erfassten Vorhandensein einer Flüssigkeit in der Bedienvorrichtung eine Signalauswertung des Bedienelements (24a..d) angepasst wird.
